# EUROPEAN PATENT APPLICATION

(11) **EP 1 271 363 A2**
(43) Date of publication of application: **02.01.2003**
(21) Application number: 01121382.4
(22) Date of filing: 06.09.2001
(51) Int. Cl.: G06F 17/50

(54) **Interface based design using a tabular paradigm**

(30) Priority: 11.06.2001 US 879828
(71) Applicant: Mentor Graphics Corporation, Wilsonville, Oregon 97070-7777 (US)
(72) Inventor: Dane, Mark, W.P, Oxfordshire (GB); Bahra, Avtar, Singh, Workingham RG4 3AZ (GB); Bold, Stephen L., Newbury, Berkshire RG14 2PU (GB); Najm, Shahram, Reading, Berkshire RG6 4BY (GB); Surti, Nitin, Berkshire RG19 3YN (GB)
(74) Representative: Patentanwälte Leinweber & Zimmermann

(57) **Abstract**

A method of creating an interfaced based representation of an electronic design is provided. Rows and columns are added to tables. These rows and columns represent signals and instances in the electronic design being represented by the description. The cells created by the table that results from the rows and column provide interconnect information.

## Description

This utility application claims priority to provisional application 60/240,547 file on October 13, 2000. This provisional application is incorporated herein by reference.

### FIELD OF THE INVENTION

The present invention is related to the field of Electronic Design Automation. More specifically, this invention relates to the entry of electronic design descriptions in an electronic design system.

### BACKGROUND OF THE INVENTION

Leading edge integrated circuit designs are becoming increasingly vast in terms of both size and complexity. Problems brought about by this increase in complexity are exacerbated by the need to bring products to market more rapidly to meet competitive pressures. The custom user design space is no exception to this phenomenon and both Application Specific Integrated Circuits (ASICs) and Field Programmable Gate Arrays (FPGAs) designs have become multi-designer efforts. As a result, architects of designs must determine how to divide the project, among multiple designers, to facilitate an efficient design process. The traditional approach to minimize complexity is to divide a design by blocks in a hierarchical and vertical manner. Challenges for the architect include how to divide functionality between blocks to accomplish two tasks, minimize interconnect between blocks and allow for use of existing intellectual property blocks.

Dividing the design by blocks provides several advantages to the design process. First, by pushing design blocks to lower level blocks, each level of hierarchy may become less complex. Larger schematics and Hardware Description Language (HDL) representations are more prone to development errors. These development errors are, due to the size of the schematic or HDL description, harder to detect. Resultantly, a reduction in complexity makes it easier for the design team to develop and debug the schematics or HDL descriptions. Second, by dividing the design hierarchically, it enables the division of the design work among design teams. Third, proper division of design facilitates management of interconnect complexity.

However there are problems with using hierarchy to manage designs. First, hierarchy does not necessarily solve all of the problems mentioned above. For example, while introducing levels of hierarchy can make the HDL and schematic development less error prone, it still leaves the problem of the creation of HDL models or schematics for the hierarchy. Block level schematics and textual descriptions, except for trivially small ones can be too unwieldy to create. Second, the introduction of additional hierarchy has two undesired side effects. For example, there is increased simulation time due to the added interfaces. Additionally, additional hierarchy results in decreased synthesis and optimization efficiency due to complexities in optimizing across boundaries.

Even assuming that a design is properly divided, hierarchically however, designs remain time consuming to enter. For example, schematic entry requires that the designer place each gate and provide interconnect information between components. This process is very time consuming. In a similar vain, entry of designs by having the user enter hardware description language models for a design require that the designer enter a textual description of components. Such a description still requires that a designer manage the connectivity between components by matching outputs to inputs in a text file.

### BRIEF DESCRIPTION OF THE DRAWINGS

Figure 1 - Embodiment of an Interface Based Design table.
Figure 2 - Schematic diagram showing equivalent representation of the interface based design table of Figure 1.
Figure 3 - Embodiment of an interface based design table with multiple module instantiations.
Figure 4 - Schematic diagram that would be the equivalent of the interface based design table of Figure 3.
Figure 5A & 5B - VHDL model for embodiment of present invention shown in Figure 3.
Figure 6A & 6B - Flowchart showing method of creating HDL model from an embodiment of the present invention.
Figure 7A - Embodiment of an interface based design table showing arrays of modules and signals.
Figure 7B - Schematic diagram that would be the equivalent of the interface based design table of Figure 7A.
Figure 8 - Details for use of a signal in one embodiment of the present invention.
Figure 9 - Details for use of a signal vector in one embodiment of the present invention.
Figure 10 - Details for use of a signal array in one embodiment of the present invention.
Figure 11 - Details for use of a signal vector array in one embodiment of the present invention.
Figure 12 - Embodiment of the present invention showing signal attributes, module attributes and comments.
Figure 13A & 13B - VHDL module for the ICT embodiment shown in Figure 12.
Figure 14 - Interconnect Table for a first portion of a design.
Figure 15 - Interconnect Table for a second portion of a design.
Figure 16 - Interconnect Table for a complete representation of a design formed by merging the Interconnect Tables of Figures 14 and 15.
Figure 17 - Hardware to run an embodiment of the present invention.
Figure 18 - A block diagram of a software solution embodying the present invention as well as other design entry tools.
Figure 19 - Example of an Interconnect Table containing a bundle with expanded bundle components.
Figure 20 - The Interconnect Table of Figure 19 showing the effect of collapsing the expanded bundle.

### DETAILED DESCRIPTION OF THE INVENTION

In the following description, various aspects of the present invention will be described. However, it will be apparent to those skilled in the art that the present invention may be practiced with only some or all aspects of the present invention. For purposes of explanation, specific numbers, materials and configurations are set forth in order to provide a thorough understanding of the present invention. However, it will also be apparent to one skilled in the art that the present invention may be practiced without the specific details. In other instances, well-known features are omitted or simplified in order not to obscure the present invention.

Parts of the description will be presented in terms of operations performed by a processor based device, using terms such as data, tables, requesting, determining, retrieving, displaying, and the like, consistent with the manner commonly employed by those skilled in the art to convey the substance of their work to others skilled in the art. As well understood by those skilled in the art, the quantities take the form of electrical, magnetic, or optical signals capable of being stored, transferred, combined, and otherwise manipulated through mechanical and electrical components of the processor based device; and the term processor include microprocessors, micro-controllers, digital signal processors, and the like, that are standalone, adjunct or embedded.

Various operations will be described as multiple discrete steps, in a manner that is most helpful in understanding the present invention, however, the order of description should not be construed as to imply that these operations are necessarily order dependent. In particular, these operations need not be performed in the order of presentation. Further, the description repeatedly uses the phrase "in one embodiment", which ordinarily does not refer to the same embodiment, although it may. Finally, "a portion of an electronic design" may refer, in addition to only a subsection of an electronic design, to a complete representation of the electronic design.

### Abbreviations

This section contains the definitions for abbreviations that are used throughout this document. Some are well know to those skilled in the art. Others are defined within this patent application.
**ASIC -** Application Specific Integrated Circuit
**FPGA -** Field Programmable Gate Array
**HDL -** Hardware Description Language
**ICT -** Interconnect Table
**IC -** Integrated Circuit
**IBD -** Interface Based Design

### Overview

What is desired is a way of solving the problems associated with hierarchy management and time consuming design entry. The present invention advantageously facilitates the rapid entry of complex design using a compact format, while at the same time reducing the issues associated with improper or non-optimal interface descriptions. Additionally the present invention facilitates provision of clear and concise documentation for a design by combining the reduction of designer entered data with the ability to rapidly make non-mutually exclusive sub-interconnect tables..

Traditional methods of representing a design at a given level of hierarchy either involve the drawing of a schematic or block diagram, or writing textual descriptions via a netlist or HDL representation. The present invention describes a novel method of representing a design at a given level of hierarchy. Specifically, an Interface Based Design paradigm is disclosed that augments the traditional methods of design entry with an extremely compact tabular format called a Interconnect Table (ICT). An ICT, or simple table herein, is a spreadsheet-like interface for entering, in a compact manner, connectivity information between components as well as other information important to the design description process. Since the tabular representation is so compact, a very complex netlist can be described rapidly in very little space.

Through the use of tables to represent a portion of an electronic design, a level of hierarchy of a design can be described in a modular fashion and subsequently combined together in a seamless manner. This facilitates the division of design work by teams while greatly simplifying the integration of design efforts. This tabular paradigm will work for board design as well as IC design.

### Table Fundamentals

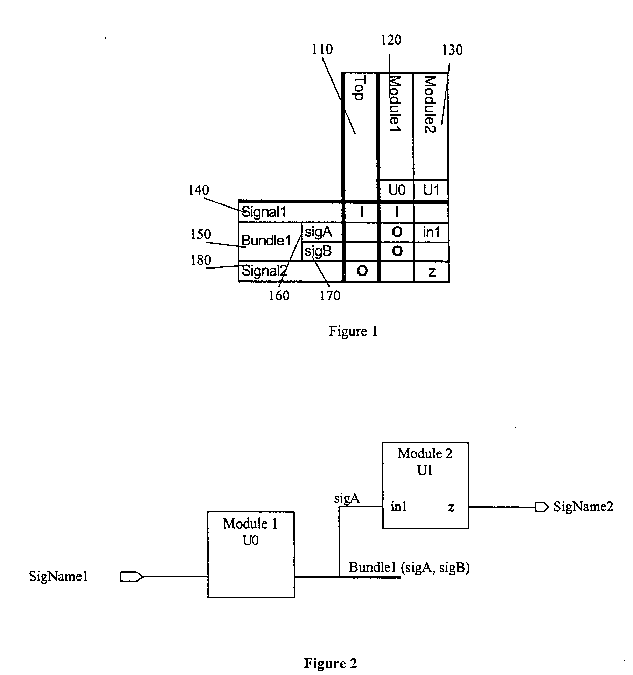

Figure 1 shows one embodiment of a basic table for the present invention. This table represents a view of a design. This view of Top contains two instances, Module1 **120** and Module2 **130**. Instances can be instantiations of components of the design, instantiations of external intellectual property components, blocks or any other object that is a constituent element of an electronic design.

In this embodiment of the present invention, the second column **110**, after the column of signal names, is a special column called the interface column that defines the design and the interface for that design. The interface is defined by sigName1 **140** and sigName2 **180.** sigName1 **140** is the sole input to this view and sigName2 **180** is the sole output. Figure 2 shows a corresponding block diagram for the table that is shown in Figure 1.

In this embodiment of the present invention, the signal names are shown in the rows of the table and the instances are shown in the column. However, signals can be shown in columns and instances can be shown in rows. At the intersection of a row and a column is a cell that is termed a synapse. An empty synapse indicates that there is no connectivity between the signal corresponding to the intersecting row and the instance associated with the intersecting column.

In the present embodiment, a header column contains the names of the signals that exist for the current level of hierarchy. As can be seen for this embodiment, there are 4 signals: sigName1, sigName2, sigA and sigB. Similarly, this embodiment contains a header row containing, among other things, information for instances that appear in the current level of hierarchy.

In the present embodiment, the input and outputs can be seen by the interface column **110** of the table. As indicated at the intersection of the interface column **110** and the row corresponding to signal *SigName1* **140,** by the inclusion of the "I" in the synapse, *SigName1* is an input to the view Top. Similarly, at the intersection of the interface column **110** and the row corresponding to signal *SigName2* **180***,* by the inclusion of the "O" in the synapse, *SigName2* is an output of Top.

By the use of generic indications of port direction in the table (e.g "I" for input and "O" for output as above), the formal port declarations for *Module1* would use the same names as the signal names in the view. For example, if a VHDL model is written for this table shown, the component declaration for *Module1* would show that the port names for the input and two output ports would be the same as those defined for the signals connected to those ports, namely SigName1, SigA and SigB, respectivly.

The third column **120** shows the instance of a component called *module1* whose identifier is U0. Looking at the intersection of this column **120** and the rows in the table, we see that this instance has an input signal, *SigName1* **140** and two output signals, *sigA* **160** and *sigB* **170.** Note a feature of this embodiment of the invention that provides for the division of the row containing a bundle, also called a protocol, into sub rows. A bundle is a collection of two or more signals. Each corresponding sub row contains the name of a component signal or perhaps a sub-composite of component signals. For example, instance U0 has a bundle, whose name is "Bundle1" **150** as a composite of output signals "sigA" **160** and "sigB" **170**.

The last column **130** in this embodiment shows an instance of a component called "module2" whose identifier is U1. This instance has a single input and a single output. Notice that instead of a simple indication of the direction that the corresponding port on an formal component description would have with respect to a signal, e.g. an "I" or and "O", the entries for U1 have the names of the corresponding formal port names for the module *Module2.* In addition, we see that U0 drives the sole output to the current block, SigName2 **180.**

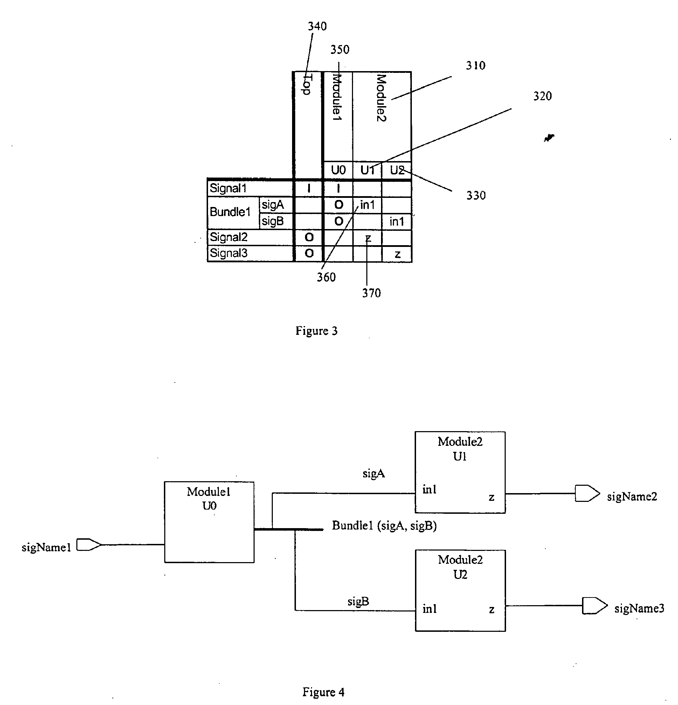

Figure 3 shows another embodiment of the present invention. The schematic diagram, which would result from the table of Figure 3, is shown in Figure 4. This embodiment shows an implementation containing multiple instantiations of a component. *Module2* **310** is instantiated twice as shown in Figure 4. The instances of *Module2* are U1 **320** and U2 **330.**

### Design Description Output

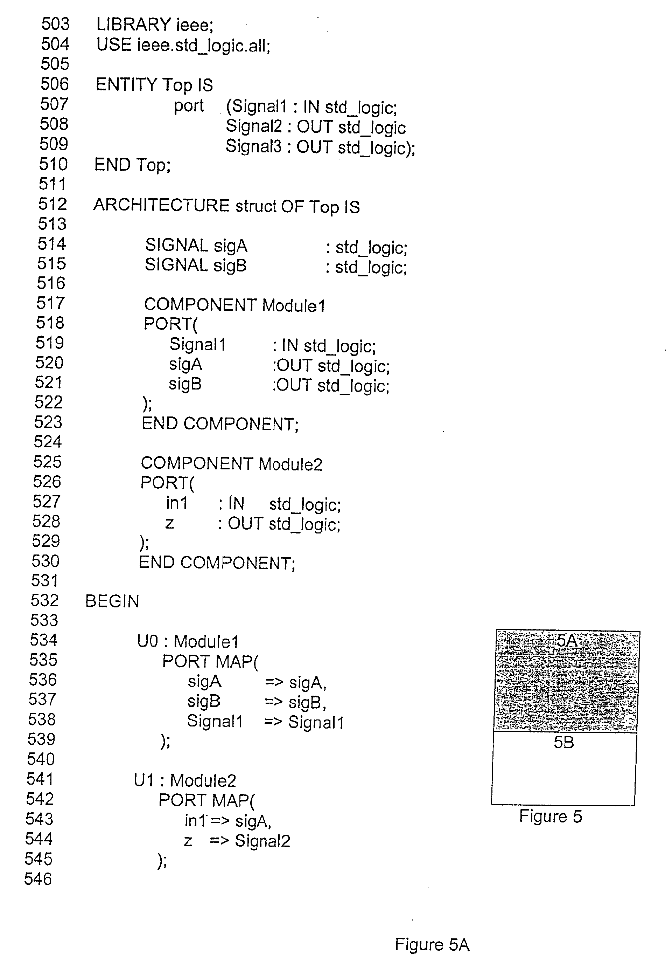

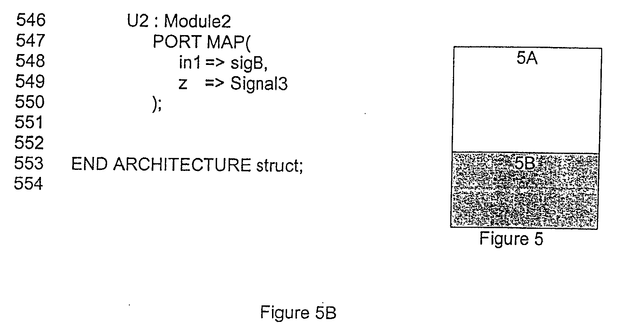

As discussed below, there may be computer implementations of the present invention. To facilitate subsequent usage by downstream tools of a design description created using the present invention on these computer systems, it is desirable to have the ability to output the description of a design. In one embodiment of the present invention, the tabular format can be written out into a HDL representation. For an example, refer again to Figure 3. Recall that Figure 3 shows an ICT representation of a design. Figures 5A and 5B show a corresponding description in the hardware description language VHDL for this table.

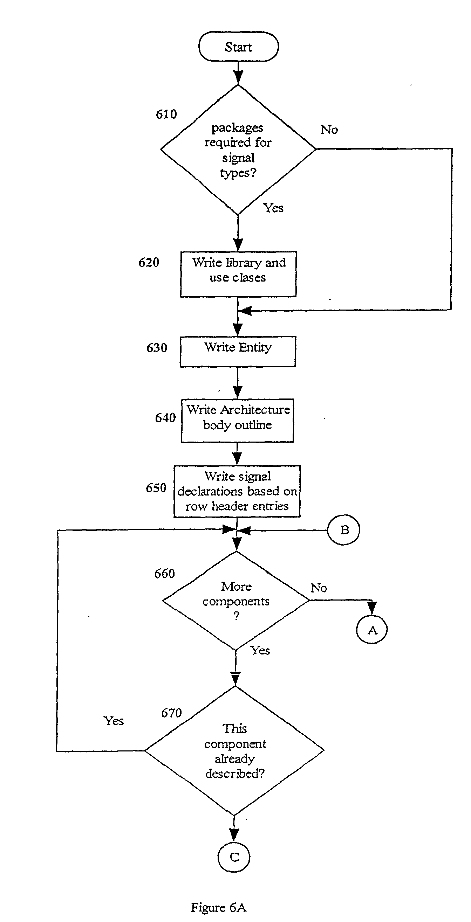

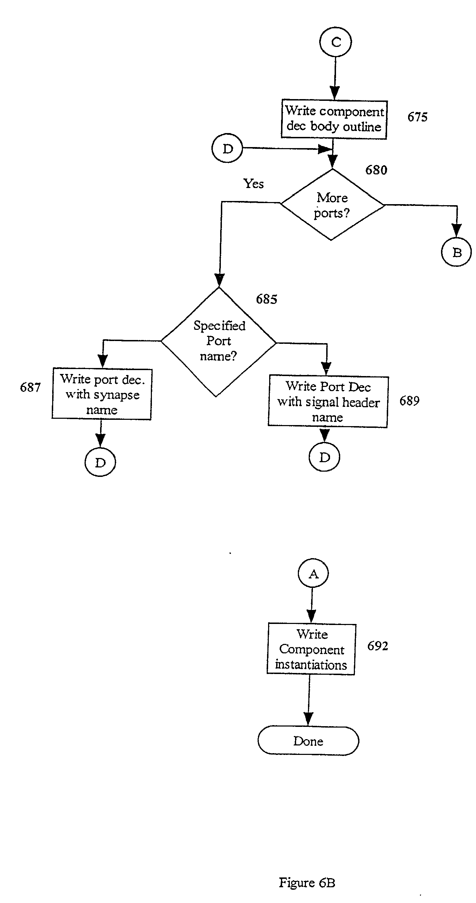

Figures 6A and 6B show a flow chart for one embodiment of writing the VHDL model of Figures 5A and 5B from the table of Figure 3. The first step **610** in the writing of the VHDL model is the determination of which packages are in use and consequently which library and use clauses **620** are required. In this example, this determination is made based on the signal types in use. Determination of signal types will be discussed below. Lines **503** and **504** show declarations for the IEEE library containing the definitions for the std_logic signal type used in this example. Next **630,** lines **506-510** show the VHDL entity statement that is written out, based on the name of the interface and its ports, as described in the interface column **340**. The interface name from the column translates to the entity name **506**. The ports on the entity are derived from the synapses containing the appropriate indication (in this embodiment "I" for inputs and "○" for outputs) in the interface column. From this we see that Signal1 **507** is the sole input to the entity Top and Signal2 **508** and Signal3 **509** are the outputs. Next, the body outline **512, 532, 554** for the architecture are written **640.** After the body outline for the architecture is written, the signal declarations for the body need to be determined **650**. These signals are simply the signals that appear in the table that are not already declared in the entity declaration. Such signals are to be written in the declarative portion of the architecture body. In this example, these signals are the two constituent signals for bundle Bundle1, namely *sigA* **514** and *sigB* **515.** In the declarative section, after the signal declarations are written, the component declarations are to be written. In this embodiment, these are indicated by the columns of the table to the right of the interface column. While there are three columns in this example, there are only two components shown in Figure 3. The three columns contain instances U0, U1, U2 and components Module1 **350** and module2 **310.** After determining whether there are instances still to be processed **660**, we begin by processing the first column to the right of the interface column **670**. In this case we ask if the component associated with this instance has already been written. In the case with U0, the answer is no and the component for Module1 is written **517-523.** During subsequent iterations through this loop, the processing of U1 will cause the component for Module2 to be written **525-530.** When U2 is to be processed, however, Module2 will already have been written and therefore step 670 will result in Module2 not being written again. In processing a component, the first step is to write out the component body declaration parts **675**. After this each port is processed on the component **680**. By looking at the contents of the synapse, it can be determined if the port has a specified port name **685**. If it does not have a specified port name, then the formal port declaration in the component are written as the names from the signal header **687**. Otherwise, the port names are taken from the synapse name **689**. As shown **527-528**, the values of the formal port declaration for Module2 are "in1" **360** and "z" **370**.

In this embodiment, the port directions for the Module2 component are determined by the existence of any driver on the signal connected to the port. In the case of "in1" (for either instance U1 or U2), the signal driving this port is connected to an output of Module1. This indicates that there is a driver on this signal and therefore the port on Module2 would be an input. By similar reasoning (again for either the U1 or U2 instance of Module2), the port "z" would be an output port. This is because there is no other driver connected to the signal to which the "z" port is connected. In one embodiment of this invention, the user will have the ability to specify in a synapse, the port direction even where there exists a formal name in the synapse for the port.

In this embodiment of the invention, after the component declarations are written and the declaration section is complete, the component instantiations are made to the statement section of the architecture. In this embodiment, we see there is a component instantiation statement for each instance in the table; U0 **534-539,** U1 **541-545** and U2 **546-550**. The interconnect for the instantiations are directly translated from the table. In the embodiment shown in Figure 5, the instantiations employ named association. For example, in the case of the U1 instantiation of Module2, the "in1" port is connected to the "sigA" signal in Top **542.** This connection is indicated by the appearance of the "in1" in the synapse intersecting *sigA* row and the *U0* column **360.** Finally, after the component instantiations are written to the statement section of the architecture, lines 551 and 552 show the breaking out of the individual signals *sigA* and *sigB* from the bundle *Bundle1.*

For use with VHDL, a signal type must be provided to enable the tool to write the description. In this embodiment, a default value is provided and is of type "std_logic". In one embodiment of the present invention, a default value of "bit" is used. In another embodiment, the default value will not be assumed and the user will specify type information in an additional column. In yet another embodiment the default value will not be assumed and the user will be prompted for a type to use for signals when the request to write the VHDL is made.

Other methods to output design descriptions to downstream tools can be used. For example, in one embodiment of the present invention, the design would be written out in Verilog HDL. In another embodiment of the present invention, the design is written out in a proprietary database format.

### Additional Table Features

### Signal and Module Arrays and Signal Vectors

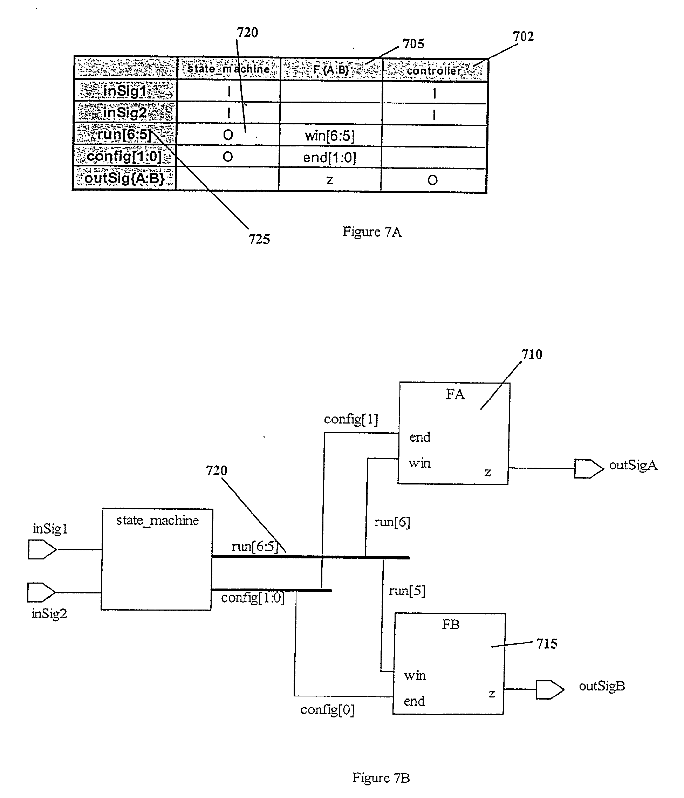

To aid in the compaction of data, one embodiment of the present invention supports the use of arrays to describe signals and modules in a design. Figure 7A shows one embodiment where signal and module arrays are used. In this example, a design whose name is *controller* is shown. In this embodiment, the last column shown is the interface column **702.** From this column, we see that *controller* has two inputs; inSig1 and inSig2. In addition, *controller* has an output, *outSig,* which is actually two signals, *outSigA* and *outSigB.* Figure 7B shows the corresponding schematic representation of the interface based design description of Figure 7A.

In this embodiment of the invention, braces are used to indicate an array of names for modules or signals. This method can be used to create a second dimension to modules and a second dimension to signal vectors. For example, referring to Figure 7A, the definition for the array of "F" modules can be shown in a column header **705**. As shown here, the syntax of F(A:B} can be used as a shorthand for generating two modules FA **710** and FB **715** as shown in Figure 7B. This array naming convention can work for alphanumerics and is a simple way to replicate slices for designs that have repeating structures.

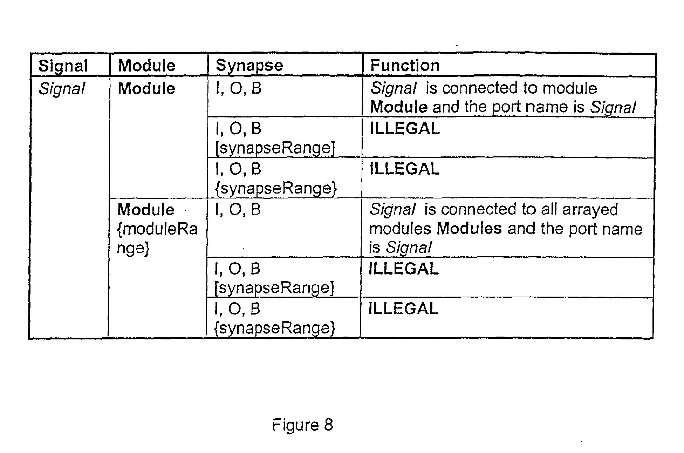

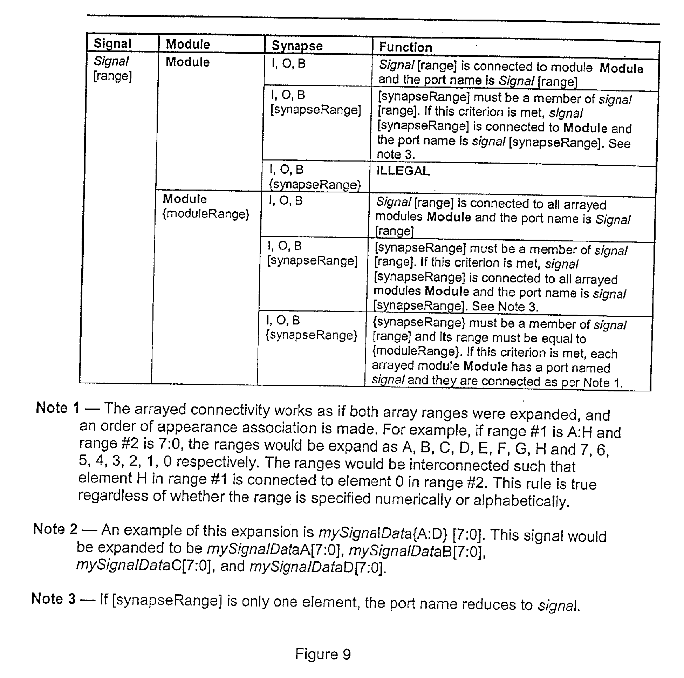

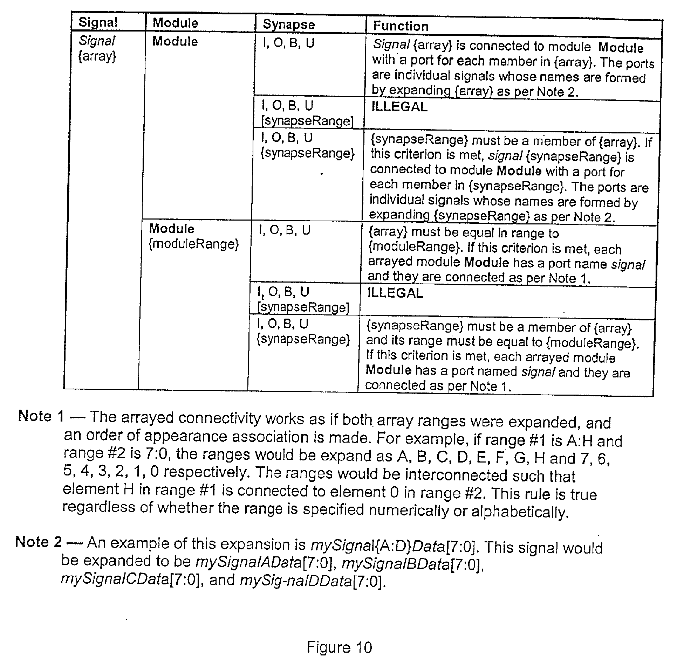

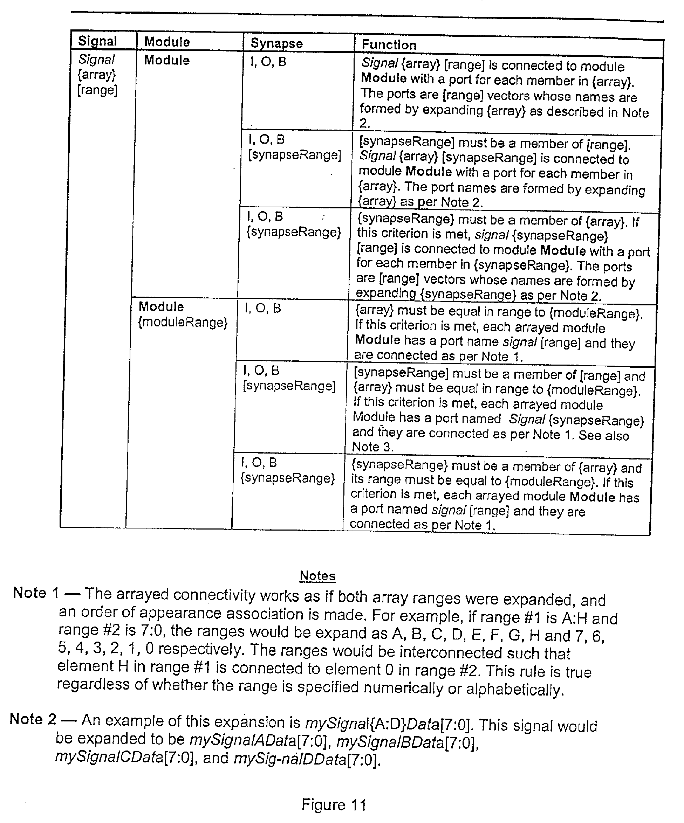

The embodiment of the present invention shown in Figure 7A also demonstrates the ability to have vectors for signals. Signal *run* is a bus that is two bits wide as denoted by the range indicator "6:5" **725.** The *run* bus is driven by the module "state_machine" **720.** In this embodiment, the positional notation of the 6:5 for the run bus is shown as being connected to a formal input port *win* on the module *F*. The A:B range indicator for the *F* module array indicates that *FA* is to have the 6 bit of the run signal driving its *win* port and *FB* is to have the 5 bit of the run signal driving its *win* port. Additional structures can be built using signal vectors on signal arrays. The tables in Figures 8 through 11 provide details on how one embodiment of the invention can handle arrays and vectors, as well as their subsets, for use in a synapse.

### Signal Attributes and comments

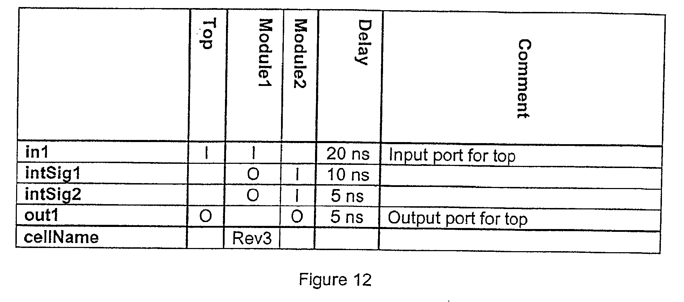

Examples of other types of columns that can exist in a table are signal attributes, instance attributes and comments. Figure 12 shows an embodiment of the present invention that contains a table with such entries.

In the embodiment shown in Figure 12, the presence of a signal attribute column indicates that when an HDL model is written out for this design, all signals generated will contain the named attribute. In this example, all signals written will contain the attribute *delay.* This is indicated by the presence of the 'delay' column header in the table. The value of the attribute is contained in the synapse that intersects the signal and the attribute. For example, the signal *in1* will have a signal attribute whose value is 20ns. In this embodiment, the existence of the attribute *delay* means that each signal that would be written when the design is output would have this attribute written regardless of the existence of a value in the synapse. In other embodiments, this may be optional depending on flags or conditions.

The embodiment shown in Figure 12 also shows a comment field. In this embodiment, comments will be written out as end line comments in an HDL file. Other embodiments can use this as simply a comment field for the table and not write out the comment when writing an HDL file or write out the comment in block comment format if the HDL supports block comments.

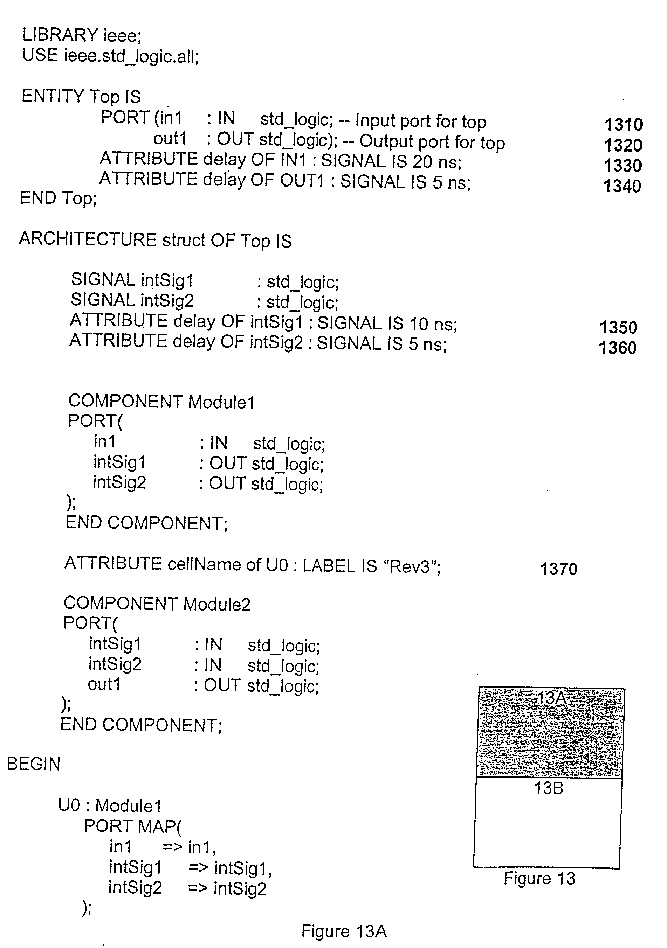

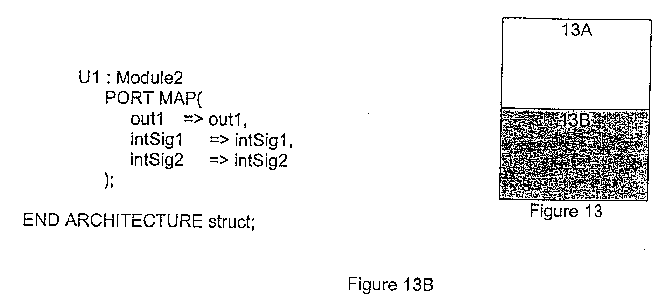

Figures 13A and 13B show an HDL listing of an output from the table of Figure 12. The port declaration statement in the entity declaration, at lines **1310** and **1320**, shows the output of the comments from the table of Figure 12. The entity declaration also shows the signal attributes for the input and output ports to the interface at lines **1330** and **1340**. The declarative part of the architecture, for the HDL written from the table of Figure 12, shows the attribute statements at lines **1350** and **1360** for the internal signals shown in the table.

For embodiments to support the ability to have non-instance columns, there needs to be some way of indicating that the column does not correspond to an instance. In embodiment shown in Figure 12, there is a hidden column type field tied to each column. This field provides information about whether a column is describing an instance of a module, a comment or a signal attribute.

### Instance Attributes

In a manner analogous to the signal attributes, an embodiment of the present invention may support instance attributes. As shown in Figure 12 and the corresponding HDL in Figures 13A & 13B, there is an instance attribute called cellName. As shown on line **1370,** the value of this attribute for the U0 instance of Module1 is "Rev3". Note that, in this embodiment, the behavior of the instance attributes is slightly different from the signal attributes. If there is no entry in the field for the instance attribute, the attribute is not written out. So, as shown in Figure 12, there is no entry for cellName for Module 2, resultantly there is no attribute written to the file.

### Attribute Output Options

As discussed above, in one embodiment of the invention, attribute information can be output in an HDL description of the design represented by the table. For example, a user enters attribute information that relates to a subsequent synthesis process in the columns of a table. The user may then write an internal script which will be used by an HDL generator to create in-line HDL/embedded constraints and insert them in the generated HDL file.

In one embodiment of the invention, the attribute information is output in a tab separated value (TSV) format. A user can write an external script that will access the TSV format file containing the attribute/property values and create a stand-alone constraint file that another design or verification tool may read automatically.

In yet another embodiment, the invention will generate a synthesis constraint file directly without the need for a users script. The constraint file will be in the proper format for the targeted synthesis tool that the user specifies and is to subsequently process the HDL design description file.

### Multiple Table Manipulation

### Table Merging

As mentioned, one of the advantages of the present invention is the ability to have multiple designers or teams work on different portions of a design while also facilitating easy combination of efforts into a single design representation. This can be accomplished by designing with different tables and then merging the tables together.

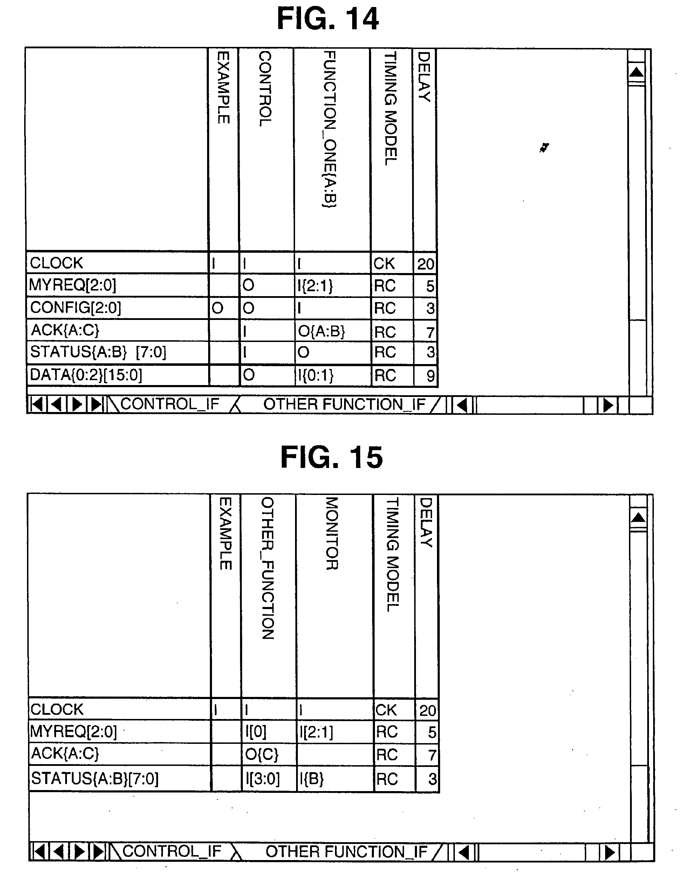

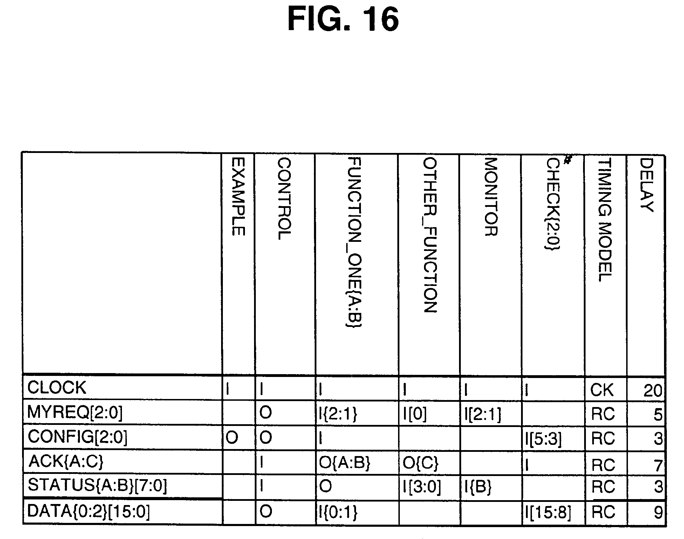

Figure 16 shows the result of one embodiment of the present invention that merges the tables in Figures 14 and 15. Figure 14 shows a portion of a design called *example* containing three blocks; two *function_one* blocks and a *control* block. Figure 15 shows another portion of the same design containing two blocks; *other_function* and *monitor.* In this embodiment of the invention, checking is performed on the two tables prior to merging. The checking looks for conflicts in data that have diverged. For example, each connection to an instance is checked to make sure that the direction, range and type match (or is handled by a type converter). Additionally, in this embodiment of the invention, signal attribute values must match exactly for the same signal in different tables. Other embodiments of the invention can establish any set of rules regarding the merging of data.

As with other tables generated by this invention, it may be desirable to have a table exported by an embodiment of the present invention. This exporting, as previously mentioned may be in the form of an HDL. In one embodiment of this invention involving the generation of a Verilog hardware description model; multiple outputs, no outputs or no inputs are reported upon merging of tables. This information is kept and is flagged during generation of the HDL model from the merged table. This ensures that the information is communicated to the user at the time that the tool writes a model that can be used by other tools.

### Table Extraction

A component table of a design description can be created. In one embodiment of the present invention, rows of signals are selected by a user. Based on these rows of signals, the modules that drive, or are driven by, the signals in the selected row are also selected. The user selected rows of signals and the corresponding selected modules are extracted from the table and used to create a component table of the original description.

### User Device Embodiment

### Hardware

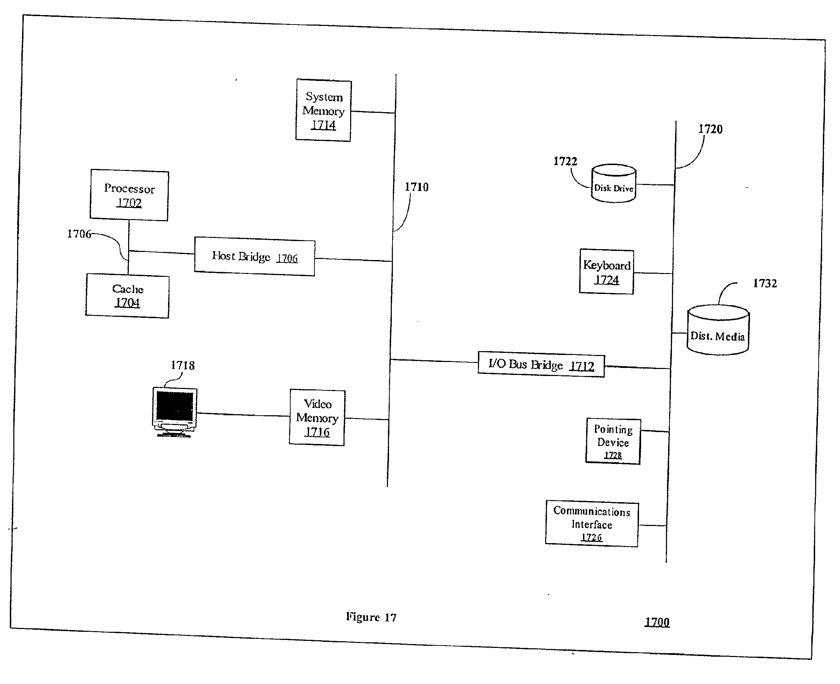

Figure 17 illustrates one embodiment of a user apparatus suitable to be programmed with the utility application of the present invention. As shown, for the illustrated embodiment, user device **1700** includes processor **1702**, processor bus **1706**, high performance I/O bus **1710** and standard I/O bus **1720.** Processor bus **1706** and high performance I/O bus **1710** are bridged by host bridge **1708,** whereas I/O buses **1710** and **1720** are bridged by I/O bus bridge **1712.** Coupled to processor bus **1706** is cache **1704.** Coupled to high performance I/O bus **1710** are system memory **1714** and video memory **1716**, against which video display **1718** is coupled. Coupled to standard I/O bus **1720** are disk drive **1722,** keyboard **1724** and pointing device **1728,** and communication interface **1726.**

These elements perform their conventional functions known in the art. In particular, disk drive **1722** and system memory **1714** are used to store permanent and working copies of the mechanical design system. The permanent copy may be preloaded into disk drive **1722** in factory, loaded from distribution medium **1732**, or down loaded from a remote distribution source (not shown). Distribution medium **1732** may be a tape, a CD, a DVD or other storage medium of the like. The constitutions of these elements are known. Any one of a number of implementations of these elements known in the art may be used to form computer system **1700**.

Certain embodiments may include additional components, may not require all of the above components, or may combine one or more components. Those skilled in the art will be familiar with a variety of alternative implementations.

### Software User Interface

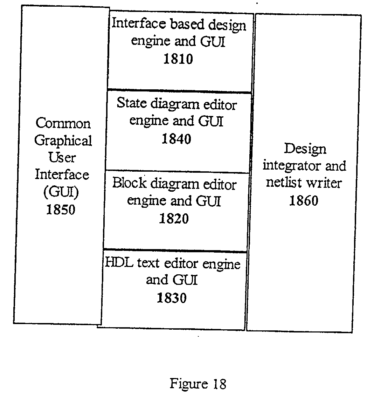

As embodied in a computer system, the present invention can be a stand-alone application or as part of a suite of design entry applications. Figure 18 shows an embodiment of the present design in a suite of design entry applications. The ICT editor **1810** is shown together with a block diagram editor **1820**, a text editor for direct entry of HDL files **1830**, and a state machine editor **1840**. In this embodiment, all the design entry applications have a common portion to the user interface **1850.** In addition, there is a common "back-end" that allows the user to combine different designs and have them written out in a hardware description language format, **1860.** As mentioned in previous discussions, the entry of information in the present invention can be in a manner that is HDL independent.

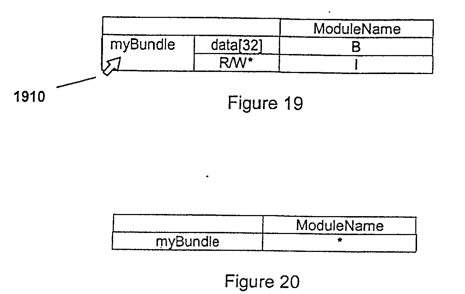

One feature of using a software interface with the present invention is the ability to collapse and expand signal bundles and buses, and signal and instance arrays. Figure 19 shows a portion of a table from the one embodiment of the present invention. In this embodiment there exists a bundle, *mybundle* **1910,** which contains two signals *data[32]* **1920** and *R*/*W* **1930**. In this embodiment, it will be possible to collapse bundles to simplify the table. For example, in Figure 19, by double clicking on the bundle **1910,** *mybundle,* the bundle is collapsed as shown in Figure 20. In such a case, a complex connection is created. This complex connection is shown by an "*" in the table. In this computer embodiment of the present invention, the user can perform the same operation on buses and arrays of instances and signals.

In one embodiment of the present invention, the software user interface will support the ability for the user to view a block diagram from the table description. As an example, refer back to Figures 3 and 4. Figure 4 would be an example of a block diagram that would be generated from the table of Figure 3. In one embodiment of the present invention, the user can select the table and choose an option from a pull down menu to "Generate Block Diagram ...". Pull down menus are well known in the art and will not be described further. It is desirable to have the ability to view a block diagram of a table since many designers are familiar with the representation of a design in block diagram format. This enables the user to rapidly compare the table representation with that which the user is familiar - block diagrams.

In one embodiment of the present invention, the use of signal and instance attributes can be facilitated using pop-up menus in the user interface. Popup menus are known in the art and the details for implementation will not be provided. Recall from the previous discussion that embodiments of the present invention use instance and signal attributes. In this embodiment, information about VHDL packages that are to be used in the design process are provided to the interface based design tool. This can be accomplished by querying the user at setup time for the design package information. Once the design package information has been provided, the package information can be scanned to determine what types are defined for signals and instances. From this information, the current embodiment of the present invention can build a list of the available attributes for signals and instances. This list can be presented to the user, for example, via a pop-up menu when the user has a pointing device over the table.

### Conclusion

Thus, it can be seen from the above descriptions, a novel method of providing a compact description of the interconnect for a given level of hierarchy of a design is provided. Such descriptions enable a more rapid entry of complex designs using a compact format for representation of such designs.

## Claims

1. A method comprising:
receiving input to create an interface based representation of a portion of an electronic design;
generating a table based on the input, the table comprising a row, a first column, and a second column, the row corresponding to a signal in the portion of the electronic design, the first column corresponding to a first instance in the portion of the electronic design, and the second column corresponding to a second instance in the portion of the electronic design;
adding a first notation in the table at an intersection of the row and the first column based on the input; and
adding a second notation in the table at an intersection of the row and the second column based on the input, the first notation and the second notation representing an interconnection between the first instance and the second instance in the portion of the electronic design.

2. The method of claim 1 wherein said interconnection between the first instance and the second instance comprises connections between a plurality of ports of the first instance and a plurality of ports of the second instance.

3. The method of claim 1 wherein one or more of said first notation and said second notation comprises information indicating a direction of the interconnect between the first instance and the second instance.

4. The method of claim 1 further comprising:
receiving additional input to further define the interface based representation of the electronic design;
adding a plurality of additional rows to the table based on the additional input, each of the additional rows corresponding to one of a plurality of additional signals in the portion of the electronic design;
adding a plurality of additional columns to the table based on the additional input, each of the additional columns corresponding to one of a plurality of additional instances in the portion of the electronic design; and
adding notations in the table at respective intersections of rows and columns to represent interconnections between one or more of the first instance, the second instance and one or more of the plurality of additional instances in the portion of the electronic design.

5. The method of claim 1 wherein the row comprises at least one cell which contains a signal name of the corresponding signal.

6. The method of claim 3 wherein the information indicating the direction comprises one of "O", 'I', "B" or "U".

7. The method of claim 4 wherein at least two of the plurality of additional columns represent separate instances of a component.

8. The method of claim 4 further comprising adding at least one further column, each of the added further columns corresponds to one of one or more signal attributes for selected additional signals in the portion of the design representation.

9. A method comprising:
receiving a first interface based representation of a first portion of an electronic design;
receiving a second interface based representation of a second portion of the electronic design;
generating a table based on the first interface based representation of the first portion of the electronic design and the second interface based representation of the second portion wherein each row corresponds to a signal from one or more of the first interface based representation and the second interface based representation and each column corresponds to an instance from one or more of the first interface based representation and the second interface based representation.

10. The method of claim 9 further comprising receiving input to add notations in the table to indicate an interconnection between one or more instances of the electronic design, each instance represented by one of the plurality of columns.

11. A method comprising:
receiving input to create an interface based representation of a portion of an electronic design;
generating a table based on the input, the table comprising one or more rows and one or more columns, each of the rows corresponding to an instance in the portion of the electronic design and each of the columns corresponding to a signal in the portion of the electronic design;
adding notations to the table, the notations representing connectivity between instances represented by the one or more rows.

12. An apparatus comprising:
a storage medium having stored therein a plurality of executable instructions,
wherein when executed, the instructions operate the apparatus to:
receive input to create an interface based representation of a portion of an electronic design;
generate a table based on the input, the table comprising a row, a first column, and a second column, the row corresponding to a signal in the portion of the electronic design, the first column corresponding to a first instance in the portion of the electronic design, and the second columns corresponding to a second instance in the portion of the electronic design;
add a first notation in the table at an intersection of the row and the first column based on the input; and
add a second notation in the table at an intersection of the row and the second column based on the input, the first notation and the second notation representing an interconnection between the first instance and the second instance in the portion of the electronic design.; and
at least one processor coupled to the storage medium to execute the instructions.

13. The apparatus of claim 12 wherein said interconnection between the first instance and the second instance comprises connections between a plurality of ports of the first instance and a plurality of ports of the second instance.

14. The apparatus of claim 12 wherein one or more of said first notation and said second notation comprises information indicating a direction of the interconnect between the first instance and the second instance.

15. The apparatus of claim 12 wherein the instructions further operate to:
receive additional input to further define the interface based representation of the electronic design;
add a plurality of additional rows to the table based on the additional input, each of the additional rows corresponding to one of a plurality of additional signals in the portion of the electronic design;
add a plurality of additional columns to the table based on the additional input, each of the additional columns corresponding to one of a plurality of additional instances in the portion of the electronic design; and
add notations in the table at respective intersections of rows and columns to represent interconnections between one or more of the first instance, the second instance and one or more of the plurality of additional instances in the portion of the electronic design.

16. The apparatus of claim 12 wherein the row comprises at least one cell which contains a signal name of the corresponding signal.

17. The apparatus of claim 14 wherein the information indicating the direction comprises one of "O", 'I', "B" or "U".

18. The apparatus of claim 15 wherein at least two of the plurality of additional columns represent separate instances of a component.

19. The apparatus of claim 15 wherein the instructions further operate to add at least one further column, each of the added further columns corresponds to one of one or more signal attributes for selected additional signals in the portion of the design representation.

20. An apparatus comprising:
a storage medium having stored therein a plurality of executable instructions,
wherein when executed, the instructions operate the apparatus to:
receive a first interface based representation of a first portion of an electronic design;
receive a second interface based representation of a second portion of the electronic design;
generate a table based on the first interface based representation of the first portion of the electronic design and the second interface based representation of the second portion wherein each row corresponds to a signal from one or more of the first interface based representation and the second interface based representation and each column corresponds to an instance from one or more of the first interface based representation and the second interface based representation.
at least one processor coupled to the storage medium to execute the instructions.

21. The apparatus of claim 20 wherein the instructions further operate to receive input to add notations in the table to indicate an interconnection between one or more instances of the electronic design, each instance represented by one of the plurality of columns.

22. An apparatus comprising:
a storage medium having stored therein a plurality of executable instructions,
wherein when executed, the instructions operate the apparatus to:
receive input to create an interface based representation of a portion of an electronic design;
generate a table based on the input, the table comprising one or more rows and one or more columns, each of the rows corresponding to an instance in the portion of the electronic design and each of the columns corresponding to a signal in the portion of the electronic design;
add notations to the table, the notations representing connectivity between instances represented by the one or more rows.
at least one processor coupled to the storage medium to execute the instructions.

23. A machine accessible storage medium having stored thereon a plurality of executable instructions, wherein when executed, the instructions implement a method comprising:
receiving input to create an interface based representation of a portion of an electronic design;
generating a table based on the input, the table comprising a row, a first column, and a second column, the row corresponding to a signal in the portion of the electronic design, the first column corresponding to a first instance in the portion of the electronic design, and the second columns corresponding to a second instance in the portion of the electronic design;
adding a first notation in the table at an intersection of the row and the first column based on the input; and
adding a second notation in the table at an intersection of the row and the second column based on the input, the first notation and the second notation representing an interconnection between the first instance and the second instance in the portion of the electronic design.

24. The machine accessible storage medium of claim 23 wherein said interconnection between the first instance and the second instance comprises connections between a plurality of ports of the first instance and a plurality of ports of the second instance.

25. The machine accessible storage medium of claim 23 wherein one or more of said first notation and said second notation comprises information indicating a direction of the interconnect between the first instance and the second instance.

26. The machine accessible storage medium of claim 23 wherein the instructions further implement:
receiving additional input to further define the interface based representation of the electronic design;
adding a plurality of additional rows to the table based on the additional input, each of the additional rows corresponding to one of a plurality of additional signals in the portion of the electronic design;
adding a plurality of additional columns to the table based on the additional input, each of the additional columns corresponding to one of a plurality of additional instances in the portion of the electronic design; and
adding notations in the table at respective intersections of rows and columns to represent interconnections between one or more of the first instance, the second instance and one or more of the plurality of additional instances in the portion of the electronic design.

27. The machine accessible medium of claim 23 wherein the row comprises at least one cell which contains a signal name of the corresponding signal.

28. The machine accessible medium of claim 25 wherein the information indicating the direction comprises one of "O", 'I',"B" or "U".

29. The machine accessible medium of claim 25 wherein at least two of the plurality of additional columns represent separate instances of a component.

30. The machine accessible medium of claim 25 wherein the instructions further implement adding at least one further column, each of the added further columns corresponds to one of one or more signal attributes for selected additional signals in the portion of the design representation.

31. A machine accessible storage medium having stored therein a plurality of executable instructions, wherein when executed, the instructions implement a method comprising:
receive a first interface based representation of a first portion of an electronic design;
receive a second interface based representation of a second portion of the electronic design;
generate a table based on the first interface based representation of the first portion of the electronic design and the second interface based representation of the second portion wherein each row corresponds to a signal from one or more of the first interface based representation and the second interface based representation and each column corresponds to an instance from one or more of the first interface based representation and the second interface based representation.
at least one processor coupled to the storage medium to execute the instructions.

32. The machine accessible storage medium of claim 31 wherein the instructions further implement receiving input to add notations in the table to indicate an interconnection between one or more instances of the electronic design, each instance represented by one of the plurality of columns.

33. A machine accessible storage medium having stored therein a plurality of executable instructions, wherein when executed, the instructions implement a method comprising:
receiving input to create an interface based representation of a portion of an electronic design;
generating a table based on the input, the table comprising one or more rows and one or more columns, each of the rows corresponding to an instance in the portion of the electronic design and each of the columns corresponding to a signal in the portion of the electronic design;
adding notations to the table, the notations representing connectivity between instances represented by the one or more rows.
